Europäisches Patentamt

(19) European Patent Office

Office européen des brevets

(11) Publication number: **0 020 787**
**B1**

(12) **EUROPEAN PATENT SPECIFICATION**

(45) Date of publication of patent specification: **03.08.83**

(51) Int. Cl.³: **H 01 L 23/12**

(21) Application number: **80900085.4**

(22) Date of filing: **22.12.79**

(86) International application number:
**PCT/JP79/00323**

(87) International publication number:
**WO 80/01437 10.07.80 Gazette 80/15**

(54) **HIGH FREQUENCY SEMICONDUCTOR UNIT.**

(30) Priority: **26.12.78 JP  163167/78**
**28.12.78 JP  164786/78**

(43) Date of publication of application:
**07.01.81 Bulletin 81/1**

(45) Publication of the grant of the patent:
**03.08.83 Bulletin 83/31**

(84) Designated Contracting States:
**DE FR GB NL**

(56) References cited:
**JP - A - 53 136 961**
**JP - Y - 51 037 512**
**US - A - 3 626 259**
**US - A - 3 740 672**
**US - A - 3 886 505**

(73) Proprietor: **FUJITSU LIMITED**
**1015, Kamikodanaka Nakahara-ku**
**Kawasaki-shi Kanagawa 211 (JP)**

(72) Inventor: **YAMAMURA, Shigeyuki**
**9-3, Shinjo 2-chome Nakahara-ku**
**Kawasaki-shi Kanagawa 211 (JP)**
Inventor: **KOSEMURA, Kinjiro**
**1793, Shukugawara Tama-ku**
**Kawasaki-shi Kanagawa 214 (JP)**
Inventor: **SHIMA, Takao**
**924, Kamikodanaka Nakahara-ku**
**Kawasaki-shi Kanagawa 211 (JP)**
Inventor: **HIDAKA, Norio**
**1380, Kamikodanaka Nakahara-ku**
**Kawasaki-shi Kanagawa 211 (JP)**
Inventor: **FUKUTA, Masumi**
**1380, Kamikodanaka Nakahara-ku**
**Kawasaki-shi Kanagawa 211 (JP)**
Inventor: **TAKEUCHI, Yukihiro**
**878, Shimonoge Takatsu-ku**
**Kawasaki-shi Kanagawa 213 (JP)**
Inventor: **SHIMOJI, Yutaka**
**40-1, Ohya Ebina-shi**
**Kanagawa 243 (JP)**

Courier Press, Leamington Spa, England.

**0 020 787**

(74) Representative: **Muir, Ian R. et al,
HASELTINE LAKE & CO. Hazlitt House 28
Southampton Buildings Chancery Lane
London WC2A 1AT (GB)**

2

High frequency semiconductor unit

This invention relates to a high frequency semiconductor device according to the first part of claim 1. Such a device handles a high frequency signal such as a microwave frequency signal, and has a construction which provides a circuit substrate, for mounting active elements, such as transistors, and passive elements, such as capacitors and resistors, and a package for accommodating said substrate. A device according to the first part of claim 1 is known from JP—A—53 136 961.

In a presently known form of such a high frequency semiconductor device, for example, a single-stage microwave amplifier, a transistor, which is hermetically sealed to prevent degradation of its characteristics and which has leads for connection to other circuit elements, is mounted on a circuit substrate and it is connected via circuits formed on said substrate with other elements which are also mounted on the same circuit substrate and which are required to form an amplifier. This circuit substrate is housed in a metal case.

In such a construction, the transistor is itself hermetically sealed and thereby occupies a relatively large space, requiring a correspondingly large circuit substrate in order to mount it and a resultantly large metal case.

Thus, the use of such single-stage amplifiers to form a multi-stage amplifier has resulted in an amplifier of a large size as a whole because of the combination of a plurality of individually large metal case single-stage amplifiers.

In a proposal to solve this problem, transistor chips are mounted together with other necessary circuit elements on a circuit substrate provided on a metal base without individual hermetical sealing and this circuit substrate is then accommodated in a metal case which is, as a whole, then hermetically sealed. However, although this structure has the advantage that the physical dimensions are reduced as compared with the previously described structure, it has at the same time the disadvantage that perfect hermetic sealing becomes more difficult because the sealing is required over a much longer sealing length than that for the individually hermetically sealed elements.

The present invention has the object of providing high frequency semiconductor devices which are compact, individually and also when combined to form a multi-stage arrangement, and which are adequately hermetically sealed.

Another object of the present invention is to provide high frequency semiconductor devices having such a configuration that a plurality of high frequency semiconductor devices functioning as amplifiers are directly cascade-connectable to form, for example, a multi-stage amplifier circuit.

These objects may be achieved according to the present invention by a high frequency semiconductor device comprising a metal base and a functional device mounted on the metal base, the base acting as an electrode for the functional device and the functional device incorporating at least one semiconductor element, a DC bias circuit for such element, high frequency circuits for connection of the element to an external circuit, a frame-shaped insulating substrate surrounding the functional device and having a plurality of separate metallised surface parts and a sealing part which with said insulating substrate and metal base, hermetically seal said functional device so that ends of said metallized surface parts can be contacted from outside, characterised in that said metallized surface parts include a metallized part for high frequency connection and a separate metallized part for DC operating power.

For a better understanding of the present invention, reference will now be made, by way of example, to the accompanying drawings, in which:

Figure 1 is a perspective view of a high frequency semiconductor device of the present invention with its sealing cover removed;

Figures 2A, 3A, 4A and 5A are plan views of the device of Fig. 1 at different stages in its manufacture;

Figures 2B, 3B, 4B and 5B are each cross-sectional views taken along the line A—A' in the corresponding one of the Figures 2A, 3A, 4A and 5A;

Figure 6 shows, in diagrammatic outline form, the parts of a functional element of a high frequency semiconductor device of the present invention—in particular an amplifier circuit of a microwave signal amplifier;

Figure 7 shows a functional block diagram circuit of the element shown in Fig. 6;

Figure 8 shows an equivalent circuit of an amplifier in the circuit shown in Fig. 7;

Figure 9 shows in plan outline form a multi-stage amplifier incorporating three devices of the kind shown in Fig. 1; and

Figure 10 is a plan view of another embodiment of the present invention at a stage in its manufacture.

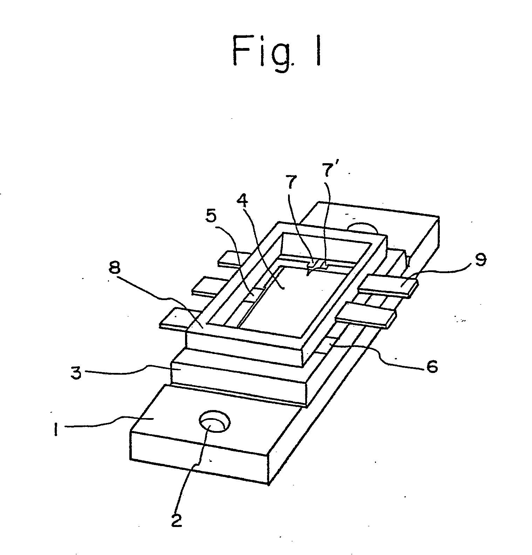

Figure 1 shows a perspective view of the outline of a high frequency semiconductor device of the present invention from which a cover for hermetic sealing has been removed. This high frequency semiconductor device may be, for instance, a microwave amplifier.

An insulating substrate 3, consisting of insulating material such as ceramic, is mounted on a metal base substrate 1 made of copper and which base is provided with mounting screw holes 2. This insulating substrate 3 is frame-shaped, i.e. it has an aperture at its center, and in its central aperture, mounted on the base 1, there is a circuit substrate 4 on which various elements are mounted to form a microwave amplifier circuit—active elements such as transistors and matching circuit components, consisting of capacitors, inductors and directional couplers. Additionally, metallized surface layers 5, 6, for providing connections between a microwave amplifier on the circuit substrate 4 and external circuits (not shown), are formed on the insulating substrate 3. One part of the metallized layer 5 is, for example, used for feeding the high frequency signal input to the microwave amplifier circuit and this layer extends from one outer edge of the insulating substrate 3 to the edge of the central aperture of the substrate as is also the case with the metallized layers 6. On the opposite side of the aperture of the insulating substrate 3, the other part of the metallized layer 5 is used as a high frequency signal output.

Each metallized layer 6 is used for supplying DC voltage to the circuit substrate 4 and its outer end is broadened and of substantially the same shape as the inner end 7 or 7'.

A total of four metallized layers 6 are formed at both sides of the metallized layers 5 provided for the high frequency signals.

The ends 7, 7' of the metallized layers 6 are disposed adjacent each other, and each is connected to the non-grounded electrode of a grounded capacitor (not illustrated) via a wire and a resistor. These metallized layers are formed by screen printing a corresponding tungsten paste coating which is then baked and thereafter nickel plated or gold plated. On the insulating substrate 3, an insulating frame 8 consisting of ceramic material is provided crossing these metallized layers, and a sealing cover (not illustrated) is in the finished device positioned thereon.

On each metallized layer outside the insulating frame 8, a lead 9 may be provided as indicated in the figure to facilitate one method of using the high frequency semiconductor device. However, Figure 1 shows a structure in which a lead is not provided at the referenced point of the metallized layer 6 for the convenience of explanation.

Each part of a high frequency semiconductor device in accordance with the present invention will be explained in more detail.

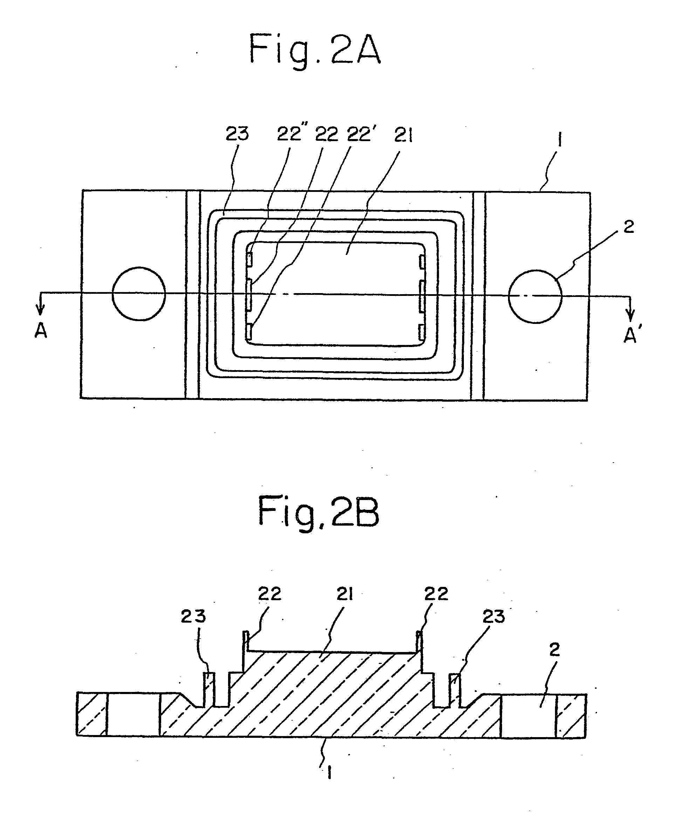

Figure 2 shows the metal base substrate 1. Figure 2A is a plan view, while Fig. 2B is a cross-section along the line A—A' of Fig. 2A. The metal base substrate 1 is provided with a base portion 21 on which the circuit substrate is mounted and projections 22, 22', 22" for grounding general parts of the circuit on the circuit substrate. Around the circumference of the base 21, a support 23 for supporting the insulating substrate is provided.

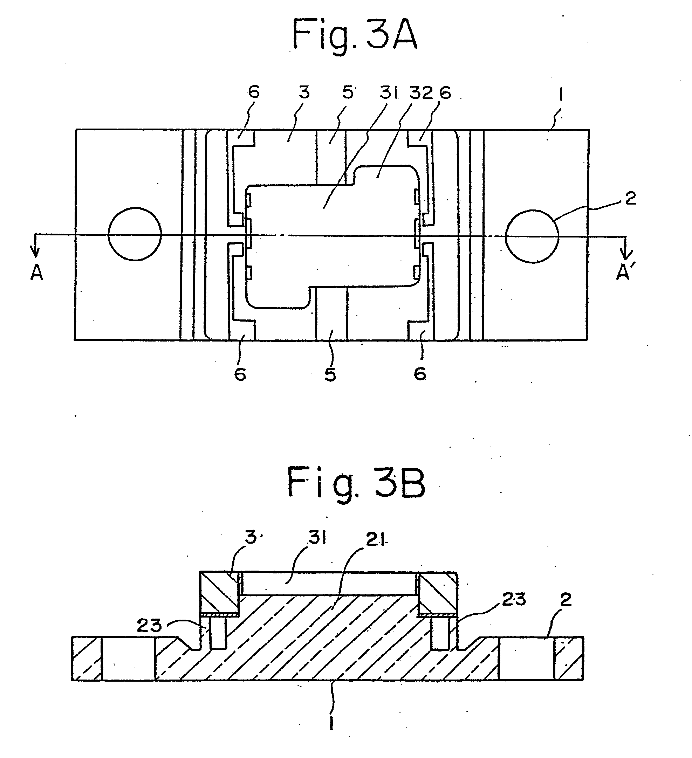

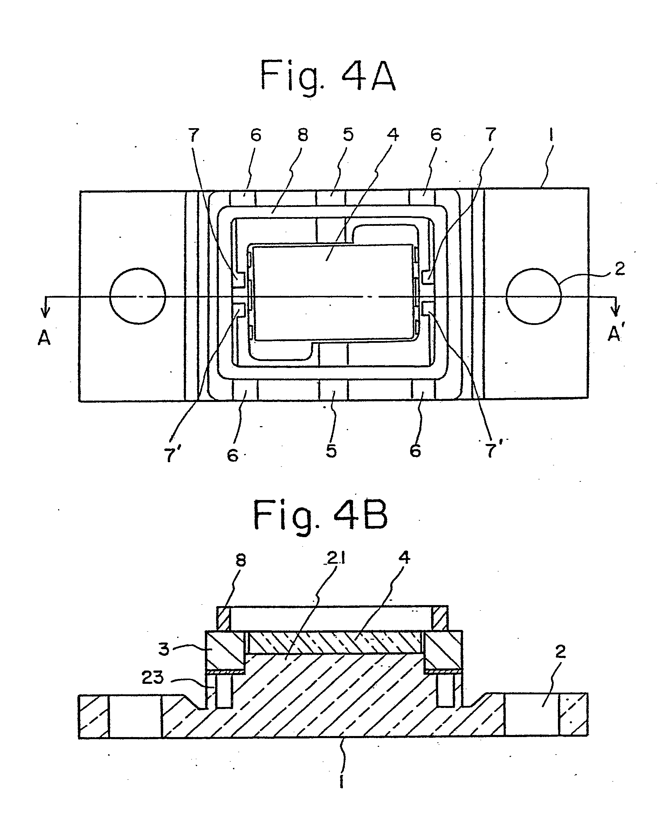

Fig. 3 shows the insulating substrate 3 mounted on the metal base substrate 1. Fig. 3A is a plan view, while Fig. 3B is a cross-section along the line A—A' of Fig. 3A. The insulating substrate 3 is supported by the circumference of base 21 and the support 23. The metal base substrate 1 and insulating substrate 3 are bonded together with silver solder. The insulating substrate 3 is provided with a hole portion 31 for accommodating the circuit substrate 4, and the edge of said hole portion 31 is provided with two diagonally opposite grooves 32 so that plating solution does not remain in the gap between the base 21 and support 23 and flows out therefrom when gold plating is performed on the metal base substrate 1 after the insulating substrate 3 is mounted thereon. Although it would be possible to see the edge of base 21 and of the circumferential substrate support portion of base 21 where they cross these grooves 32, the corresponding lines have been omitted from this Figure (and Fig. 4) for the sake of clarity. On the upper surface of insulating substrate 3 are formed the metallized layers 5, for high frequency signals, and the metallized layers 6, for supplying DC bias voltages to the microwave amplifier circuit.

Figure 4 shows the conditions where the insulating frame 8 is mounted on the insulating substrate 3 and the functional device or circuit substrate 4 is mounted on the base 21 of the metal base substrate. Fig. 4A is a plan view, while Fig. 4B is a cross-section along the line A—A' of Fig. 4A. The insulating substrate 3 and insulating frame 8 are bonded together with alumina.

The metallized layer 5 for a high frequency signal on the inner side of the insulating frame 8 is connected by wires (not shown) with the input and output ends of a directional coupler (not illustrated) on the substrate 4. Also the ends 7, 7' of the metallized layer 6 for the DC power supply is connected to an element formed on the circuit substrate 4 by wires not shown. In Fig. 4, the various elements formed on the circuit substrate 4 are not illustrated since these will be explained later in detail.

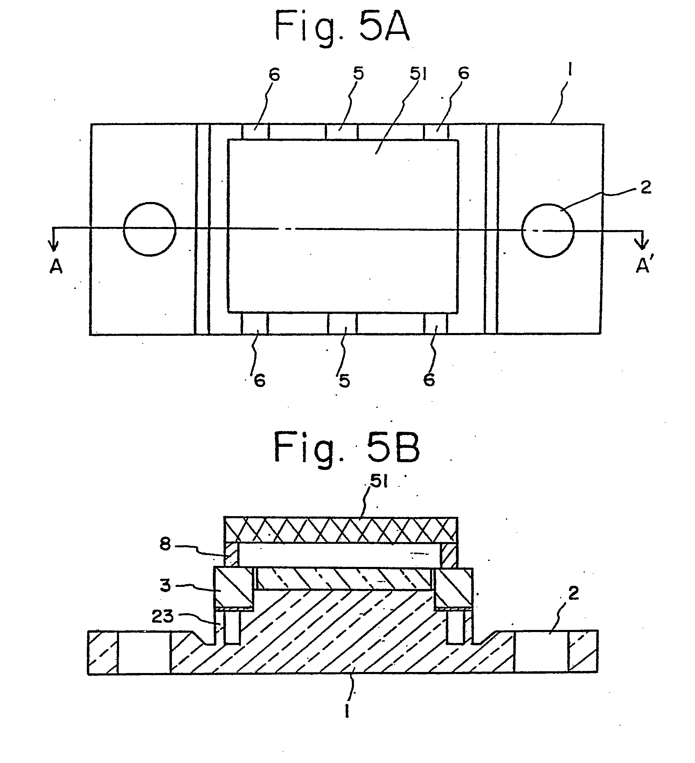

Fig. 5 shows a structure in which a cover 51 is mounted on the insulating frame 8. Fig. 5A is a plan view, while Fig. 5B a cross-section along the line A—A' of Fig. 5A.

The cover 51 is made of an insulator such as ceramic or a metal element such as covar, and is bonded to the insulating frame 8 with an alloy AuSn (20) of gold (Au) and tin (Sn).

The insulating frame 8 and cover 51 form the sealing part of a high frequency semiconductor device of the present invention. As the sealing part, a metal, for example covar, can be used in the form of an integrated frame 8 and cover 51. However, in this case, clearly, to prevent short-circuit between metallized layers, an insulator must be provided at the contact area of the metallized layers 5 and 6 and the integrated frame and cover. Also, coupling between both metallized layers can be prevented by providing a metallized layer on the insulated substrate which extends down to the metal base substrate and is positioned between the metallized layers for the high frequency signal and the DC signal.

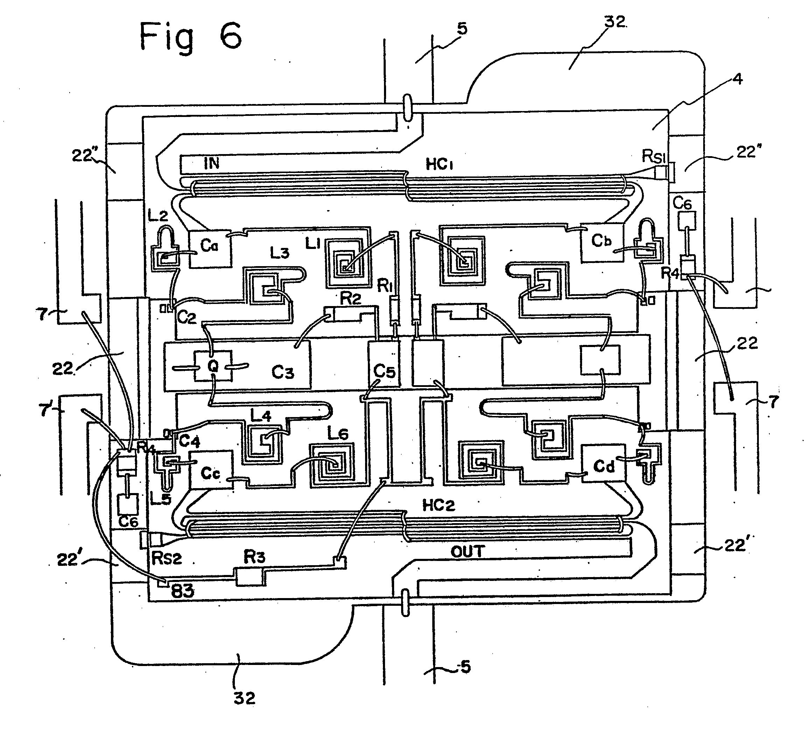

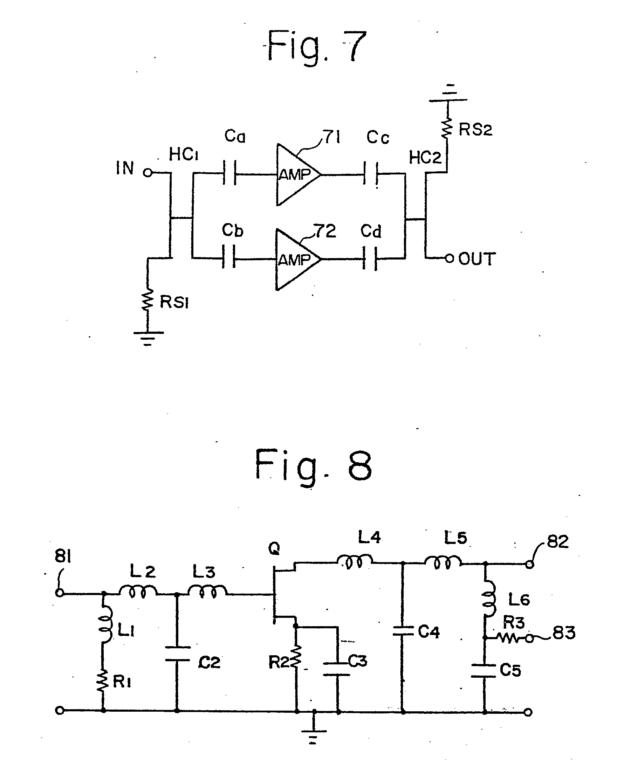

Fig. 6 shows diagrammatically a functional device of one embodiment of a high frequency semiconductor device of the present invention, in particular the amplifier circuit of a microwave amplifier. The amplifier circuit formed on the circuit substrate 4 is a balanced type amplifier circuit, having practically symmetrical characteristics for the right and left-hand sides as shown in Fig. 6. In Fig. 7 is shown the circuit configuration of the circuit of Fig. 6 and in Fig. 8 there is shown the equivalent circuit of one side of the balanced amplifier. In Figures 6, 7 and 8 the same corresponding parts are given the same references. A microwave input signal being input to the input terminal IN of the directional (hybrid) coupler HC 1 is divided into two signals therein and these divided signals are respectively amplified by the amplifiers 71 and 72, and then combined by the hybrid coupler HC 2. Thus, an amplified microwave signal is output from the output terminal OUT.

The ends opposite to the input ends of the hybrid couplers HC 1 and HC 2 are terminated respectively by the resistors $R_{s1}$ and $R_{s2}$. Ca, Cb, Cc and Cd denote DC block capacitors. The amplifiers 71 and 72 are of similar structure and, for example, an equivalent circuit of the amplifier 71 is shown in Fig. 8.

In this Fig. 8, 81 is the input end of amplifier 71 and the input matching circuit is composed of inductors $L_2$, $L_3$ and capacitor $C_2$, while the output matching circuit is formed by inductors $L_4$, $L_5$ and capacitor $C_4$; the gate self-bias circuit by inductor $L_1$, resistors $R_1$ and $R_2$, capacitor $C_3$; and the drain bias circuit by inductor $L_6$, resistor $R_3$ and capacitor $C_5$.

82 denotes the output end, while 83 denotes the DC bias input end. The physical layout of the amplifier circuit corresponding to this equivalent circuit is shown in Fig. 6.

Fig. 6 shows an enlarged view of the circuit substrate 4 on which an amplifier circuit is formed and the area near to the hole part of the insulating substrate 3.

As is obvious from the figure, the input end IN of the hybrid coupler HC 1 and the output end OUT of the hybrid coupler HC 2 are connected each to a respective one of the two metallized layers 5, formed on the insulating substrate 3, for the high frequency signal. The earthing or grounding electrodes of grounded elements, for example termination resistors $R_{s1}$, $R_{s2}$ and capacitors $C_2$, $C_4$, are connected to the projections 22, 22', 22" of the metal base substrate. Also, the areas 7, 7' of metallized layers 6 for DC power supply, are connected for each amplifier to a resistor $R_4$ by wire and the resistor $R_4$ is connected to the upper electrode of a capacitor $C_6$, the lower electrode of which is ground by connection to the metal base substrate. The DC power supply input end of the resistor $R_4$ is also connected by wire to the input end 83 of the bias circuit and thereby a bias voltage is supplied to the resistor $R_3$ forming part of the bias circuit. The metallized layer 7 could be simply directly connected to 7' by wire in order to supply the externally supplied bias voltage to the metallized layer 7' from layer 7, but resonance may occur between the facing metallized layers 7 and 7' and, therefore, high frequency signal grounding is effected through the resistor $R_4$ and capacitor $C_6$ so as to prevent such resonance. Various elements of these amplifier circuits may be provided on the monolithic substrate.

When constructing a microwave signal amplifier, for example, what is important is that not only the amplification element, such as a field effect transistor, but also that the circuits, which function with the amplification element to form the amplification circuit, such as the input/output matching circuit and directional coupler etc., are housed in a single case.

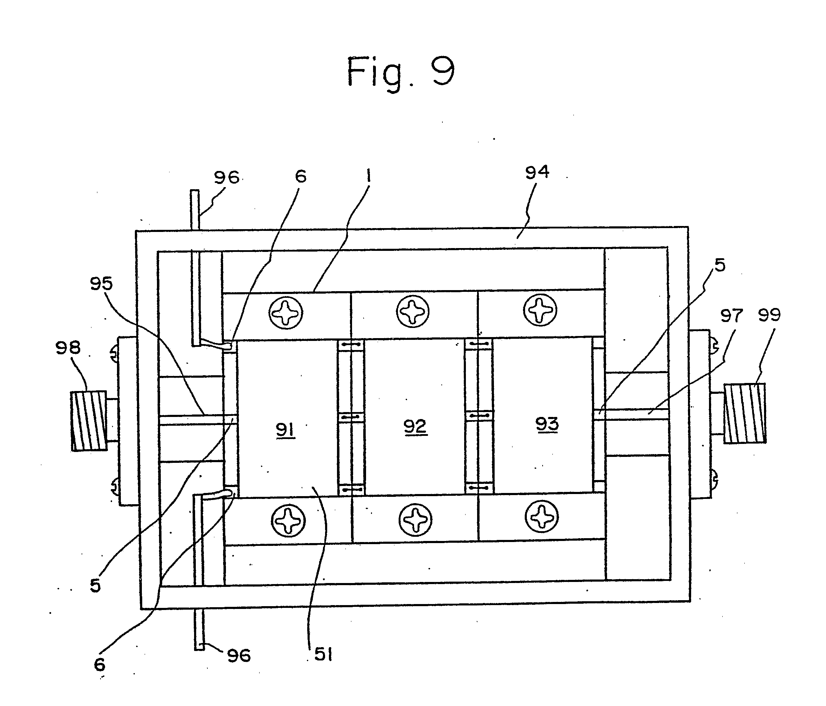

In other words, the high frequency semiconductor device itself has a complete function as an amplifier without the need for connection with any external matching circuit etc. Therefore, in the case where this device is to be used as a single-stage amplifier, the amplifier can be obtained simply by providing leads to the metallized layers. A multi-stage amplifier can be formed by connecting the appropriate number of single devices as shown in Fig. 9. Fig. 9 shows the configuration of a microwave amplifier having three stages.

When the microwave amplifiers 91, 92, 93 are fixed by screwing to a metal case 94, the metallized layers for DC and high frequency are positioned adjacent one another by side-by-side arrangement of each metal base substrate 1. Thus, the microwave signal input from an input connector 98 of the metal case is amplified by three amplifiers 91, 92, 93 and then output from an output connector 99 by connecting together the above-mentioned adjacent metallized layers with wire or conductive ribbon, the high frequency metallized input layer 5 of the microwave amplifier 91 to a strip line 95, the DC metallized layer 6 to bias terminals 96 provided in the metal case 94 and also the high frequency metallized output layer 5 of the microwave amplifier 93 to a strip line 97. The bias voltage which is required for the functioning of the amplifiers is supplied to the amplifiers 91, 92 and 93 only by connecting the bias power supply to the bias terminals 96. The metal case 94 requires a cover but it does not require to be hermetically sealed because each amplifier is already hermetically sealed.

As described above, such a high frequency semiconductor device of the present invention is completely functional per se. Therefore, to form a system using these devices, there is no need for the connection or interconnection of external matching circuits and a system can be formed as in the concept of the block diagram at the stage of the system design. For this reason, system assembly can be made very easily.

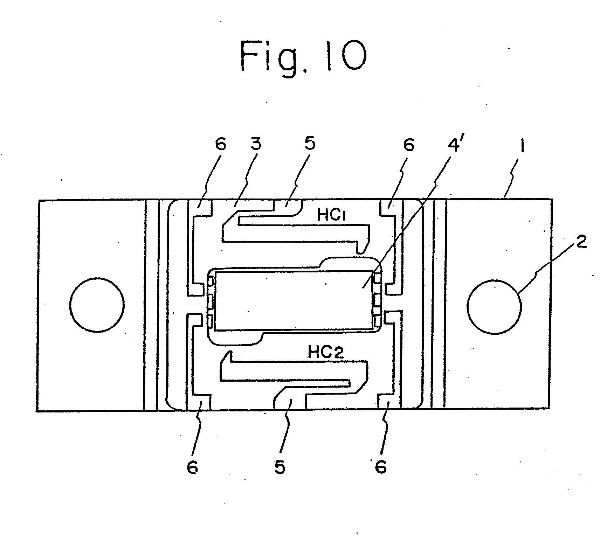

Fig. 10 shows another embodiment of the present invention indicating a structure at the stage of construction at which an insulating frame is not installed as in Fig. 3. However, the circuit substrate 4′ is shown housed in the hole part of the frame-shaped insulating substrate 3.

In this embodiment, the hybrid couplers HC1, HC2, which are mounted on the circuit substrate in the first embodiment, are provided on the insulating substrate 3. The hybrid coupler used particularly in the balance type amplifier circuit of a high frequency semiconductor device cannot be reduced in size, since the coupling part requires a length of 1/4 of the wavelength of the operating signal frequency, even though other elements can be reduced in size.

Thus, disposition of the hybrid couplers on the insulating substrate can permit reduction in the size of the circuit substrate 4′. In the case where expensive sapphire is used as the circuit substrate, a much greater number of circuit substrates can be obtained from a sheet or wafer and, therefore, the cost per circuit substrate can be reduced. Not only the hybrid coupler but also other elements may be formed on the insulating substrate.

As explained above, the present invention is capable of offering a high frequency semiconductor device which is small in size, provides sufficient sealing and ensures easy system assembling.

## Claims

1. A high frequency semiconductor device comprising a metal base (1) and a functional device (4) mounted on the metal base, the base acting as an electrode for the functional device and the functional device incorporating at least one semiconductor element (Q), a DC bias circuit ($R_2$, $C_3$; $R_3$, $C_5$) for such element, high frequency circuits ($L_2$, $L_3$; $C_2$; $L_4$, $L_5$, $C_4$) for connection of the element to an external circuit, a frame-shaped insulating substrate (3) surrounding the functional device and having a plurality of separate metallised surface parts and a sealing part (8, 51) which with said insulating substrate (3) and metal base (1), hermetically seal said functional device (4) so that ends of said metallized surface parts can be contacted from outside, characterised in that said metallized surface parts (5, 6) include a metallized part (5) for high frequency connection (5) and a separate metallized part (6) for DC operating power.

2. A high frequency semiconductor device as claimed in claim 1, characterised in that said plurality of metallized parts (5, 6) are so positioned as to facilitate cascade-connection of a plurality of adjacently positioned such devices (Fig. 9).

3. A high frequency semiconductor device as claimed in any preceding claim, characterized in that at least one circuit element of the device (HC1, HC2) is mounted or formed on said insulating substrate (3).

4. A high frequency semiconductor device as claimed in any preceding claim, characterized in that at least one component element of said functional device is formed monolithic.

5. A high frequency semiconductor device claimed in any preceding claim, wherein each device comprises two metallized parts (5) for high frequency connection and two metallized parts (6) for DC operating power, the two parts in each case being separated one from another and located to permit a plurality of devices to be positioned side by side in cascade connection with corresponding adjacently positioned DC and high frequency metallized parts (Figs. 9, 10).

## Revendications

1. Composant semi-conducteur à haute fréquence comprenant une base métallique (1) et un composant fonctionnel (4) monté sur la base métallique, la base se comportant comme une électrodepour le composant fonctionnel et le composant fonctionnel comprenant au moins un élément semi-conducteur (Q), un circuit de polarisation continue ($R_2$, $C_3$ ... $R_3$, $C_5$) pour cet élément, des circuits à haute fréquence ($L_2$, $L_3$ ... $C_2$, $L_4$, $L_5$, $C_4$) pour la connexion de l'élément à un circuit extérieur, un substrat isolant (3) en forme de cadre entourant le composant fonctionnel et comportant plusieurs parties de surface séparées métallisées, et une partie d'étanchéité (8, 51) qui, avec ledit substrat isolant (3) et la base métallique (1) enferme hermétiquement ledit composant fonctionnel (4) de manière que les extrémités desdites parties de surface métallisées puissent être mises en contact avec l'extérieur, caractérisé en ce que lesdites parties de surface métallisées (5, 6) comprennent une partie métallisée (5) pour la connexion à haute fréquence (5) et une partie métallisée séparée (6) pour l'alimentation en courant continu.

2. Composant semi-conducteur à haute fréquence selon la revendication 1, caractérisé en ce que lesdites plusieurs parties, métallisées (5, 6) sont positionnées de manière à faciliter la connexion en cascade de plusieurs de ces composants positionnés de façon adjacente (Fig. 9).

3. Composant semi-conducteur à haute fréquence selon l'une quelconque des revendications précédentes, caractérisé en ce qu'au moins un élément de circuit du composant (HC1, HC2) est monté ou formé sur ledit substrat isolant (3).

4. Composant semi-conducteur à haute fréquence selon l'une quelconque des revendications précédentes, caractérisé en ce qu'au moins un élément constituant dudit composant fonctionnel est formé de façon monolithique.

5. Composant semi-conducteur à haute fréquence selon l'une quelconque des revendications présentes, dans lequel chaque composant comporte deux parties métallisées (5) pour la connexion à haute fréquence et deux parties métallisées (6) pour l'alimentation en courant continu les deux parties dans chaque boîtier étant séparées l'une de l'autre et positionnées de manière à permettre plusieurs composants puissent être positionnés côte à côte en connexion en cascade avec des parties métallisées à courant continu et à haute fréquence positionnées de façon adjacente correspondante (Figures 9, 10).

## Patentansprüche

1. Hochfrequenz-Halbleitereinheit mit einer Metallbasis (1) und einer Funktionseinrichtung (4), welche auf der Metallbasis angeordnet ist, die als Elektrode für die Funktionseinrichtung dient, welche wenigstens ein Halbleiterelement (Q), einen Gleichstrom-Vorspannungskreis ($R_2$, $C_3$; $R_3$, $C_5$) für eine solches Element, Hochfrequenzkreise ($L_2$, $L_3$; $C_2$: $L_4$, $L_5$, $C_4$) zur Verbindungs des Elements mit einem äußeren Kreis, und ein rahmenförmiges, isolierendes Substrat (3) umfaßt, welches die Funktionseinrichtung umgibt und eine Mehrzahl von separaten, metallisierten Oberflächenabschnitten und einen Versiegelungsteil (8, 51) aufweist, welcher mit dem genannten isolierenden Substrat (3) und der Metallbasis (1) die Funktionseinrichtung (4) hermetisch so versiegelt, daß die Enden der genannten metallisierten Oberflächenabschnitte von außerhalb der Funktionseinrichtung kontaktiert werden können, dadurch gekennzeichnet, daß die metallisierten Oberflächenabschnitte (5, 6) einen metallisierten Abschnitt (5) für einen Hochfrequenzanschluß (5) und einen separaten metallisierten Abschnitt (6) für Gleichstrom-Betriebsenergie aufweisen.

2. Hochfrequenz-Halbleitereinheit nach Anspruch 1, dadurch gekennzeichnet, daß die genannten metallisierten Abschnitte (5, 6) so angeordnet sind, daß sie eine Kaskadenverbindung einer Mehrzahl von nebeneinander angeordneten derartigen Einheiten (Fig. 9) ermöglichen.

3. Hochfrequenz-Halbleitereinheit nach einem der vorhergehenden Ansprüche, dadurch gekennzeichnet, daß wenigstens ein Schaltungselement der Einheit (HC1, HC2) auf dem genannten isolierenden Substrat (3) angeordnet oder ausgebildet ist.

4. Hochfrequenz-Halbleitereinheit nach einem der vorhergehenden Ansprüche, dadurch gekennzeichnet, daß wenigstens ein Bauelement der genannten Funktionseinrichtung monolithisch ausgebildet ist.

5. Hochfrequenz-Halbleitereinheit nach einem der vorhergehenden Ansprüche, dadurch gekennzeichnet, daß jede Einrichtung zwei metallisierte Abschnitte (5) für Hochfrequenzanschluß und zwei metallisierte Abschnitte (6) für Gleichstrom-Betriebsenergie umfaßt, daß die beiden Abschnitte in jedem Gehäuse getrennt voneinander und so angeordnet sind, daß eine Mehrzahl von Einheiten Seite an Seite in Kaskadeverbindung mit entsprechend benachbart angeordneten metallisierten Gleichstrom- und Hochfrequenz-Abschnitten (Fig. 9, 10) angeordnet werden können.

# Fig. 1

# Fig. 2A

23  22" 22 22'  21  1

2

A ————→ ←———— A'

# Fig. 2B

22  21  22

23  23  2

1

# Fig. 3A

# Fig. 3B

# Fig. 4A

# Fig. 4B

# Fig. 5A

# Fig. 5B

Fig 6

# Fig. 7

# Fig. 8

# Fig. 9

# Fig. 10